# EUROPÄISCHE PATENTSCHRIFT

(11) **EP 3 388 170 B1**
(45) Veröffentlichungstag und Bekanntmachung des Hinweises auf die Patenterteilung: **11.08.2021**
(21) Anmeldenummer: 16873451.5
(22) Anmeldetag: 06.12.2016
(51) Int. Cl.: B22F 1/00, B22F 3/04, B22F 3/093, B22F 5/12, B23K 15/00, C22C 5/04, B23K 103/08, C30B 35/00

(54) **VERFAHREN ZUR HERSTELLUNG VON ARTIKELN AUS IRIDIUMMETALL**
METHOD FOR PRODUCING ARTICLES FROM IRIDIUM METAL
PROCÉDÉ DE FABRICATION D'ARTICLES EN IRIDIUM MÉTALLIQUE

(30) Priorität: 09.12.2015 RU 2015152955
(43) Veröffentlichungstag der Anmeldung: 17.10.2018
(73) Patentinhaber: Obschestvo S Ogranichennoi Otvetstvennostyu Nauchno - Proizvodstvennoe Ob''Edinenie ''Metally Urala'', Ekaterinburg 620142 (RU); Individual'nyj Predprinimatel' Gerasimov Aleksej Leonidovich, Ekaterinburg 620026 (RU)
(72) Erfinder: ALEKSANDROV, Evgenij Petrovich, Ekaterinburg 620146 (RU); KAZAKOV, Aleksandr Sergeevich, Ekaterinburg 620137 (RU)
(74) Vertreter: Jeck, Anton
(86) Internationale Anmeldenummer: PCT/RU2016/000849
(87) Internationale Veröffentlichungsnummer: WO 2017/099635

(56) Entgegenhaltungen:
- WO-A1-2015/175326
- CN-B- 102 814 499
- DE-C1- 3 230 389
- JP-A- H0 456 706
- JP-A- H0 456 706
- SU-A1- 366 930
- US-A- 3 447 230
- US-A- 3 518 336
- TIMOFEEV N.I. et al.: "Osnovy metallurgii i tekhnologii proizvodstva izdelii iz iridiya", Osnovy metallurgii i tekhnologii proizvodstva izdelii iz iridiya, 1996, pages 105-109, XP009511673,
- Wikipedia Contributors: "Characterization of nanoparticles", , 13 April 2020 (2020-04-13), pages 1-12, XP055694546, Retrieved from the Internet: URL:https://en.wikipedia.org/wiki/Characte rization_of_nanoparticles [retrieved on 2020-05-12]
- Wikipedia Contributors: "Specific surface area", , 15 January 2020 (2020-01-15), XP055694548, Retrieved from the Internet: URL:https://en.wikipedia.org/wiki/Specific _surface_area [retrieved on 2020-05-12]

## Beschreibung

### Erfindungsgebiet

Die vorliegende Erfindung betrifft ein Verfahren zur Herstellung von Erzeugnissen aus metallischem Nanopulver des Iridiums gemäß den Merkmalen des Anspruchs 1. Die Erfindung bezieht sich damit auf die Pulvermetallurgie und kann für den Erhalt verschiedener Erzeugnisse aus Iridium verwendet werden.

### Stand der Technik

Aus der WO 2015/175326 A1, der JPH 04056706 A und der US3447230 A sind Verfahren zur Herstellung von Erzeugnissen aus metallischen Iridium bekannt.

Iridium ist ein schwer schmelzendes Metall der Platingruppe. Die Kombination von Eigenschaften wie Hochtemperatur der Schmelze und unter den Metallen höchste chemische Trägheit macht es zu einem unersetzlichen Konstruktionsmaterial für den Gebrauch unter Bedingungen erhöhter Temperaturen (bis zu 2200°C) und aggressiven Medien. Iridium ist das einzige Metall, aus dem Erzeugnisse für spezielle Verwendungszwecke hergestellt werden, nämlich:
- Tiegel (Schmelzgefäße) für die Züchtung überdimensionaler Oxidmonokristalle, die in der Mikroelektronik und Lasertechnik anwendbar sind;
- Material für die Korpusherstellung von Kleinkernreaktoren und von Behältern der Thermogeneratoren aufgrund von Plutoniumdioxid für interplanetarische Raumfahrten;
- Scheiben für die Herstellung von Radioisotopenquellen, die in Geräten für zerstörungsfreie Prüfung und für die Behandlung von Tumorerkrankungen anwendbar sind;
- Elementdraht mit Diapason der Messtemperaturen nicht unten 2200°C;
- Elektroden für Autozündkerzen, die eine Fahrleistung von mehr als 250.000 km sichern.

Die weltweite Nachfrage nach den Erzeugnissen aus Iridium wurde im Jahr 2010 vierfach größer und betrug 10,5 Tonnen bei 2,5-facher Preiserhöhung des Iridiums. Eine stabile Industrienachfrage nach der Produktion aus dem Iridium sichert derzeit stabile Preise.

Das Hauptproblem bei der Herstellung von Erzeugnissen aus Iridium ist die hohe Empfindlichkeit seiner technologischen und Nutzungseigenschaften zum Vorhandensein von einer sogar geringen Anzahl von Dotierungselementen, die als Hauptursache des Sprödbruchs von Iridium gelten. Die traditionelle Herstellungstechnologie von Erzeugnissen aus Iridium sieht als Ausgangserzeugnisse bei der Herstellung des Materials aus Iridium die Verwendung des Monokristalls des Iridiums mit einem Fremdstoffgehalt von nicht mehr als 0,003% vor. Der Monokristall wird durch eine vorbereitende mehrstufige und energieverbrauchende Raffinationsschmelze unter Verwendung von Elektronenstrahlumschmelzen im Vakuum (ELF) gewonnen. Über die Industrietechnologie für die Gewinnung eines solchen Metalls verfügt eine begrenzte Anzahl von Herstellern, unter denen die Gesellschaften Johnson Matthey PLC (Großbritannien), W.C. Heraeus GmbH (Deutschland), Nationallabor in Oak Ridge (USA), Engelhard-Clal Corporation (USA), offene AG «Jekaterinburger Werk für Bearbeitung von Buntmetallen» und geschlossene AG« URALINTECH» Russland zu finden sind.

Hochreines metallisches Iridium-Nanopulver ist für die Bildung von neuen Konstruktionsmaterialien mit einem gewünschten Satz der physikalisch-chemischen Eigenschaften und Verbrauchereigenschaften bestimmt und ermöglicht die Bildung von grundlegend neuen effizienten technologischen Prozessen zur Herstellung der Iridium-Erzeugnisse mit verbesserten Gebrauchseigenschaften.

Hochreines metallisches Iridium-Nanopulver wird im Ergebnis der Originalkombination aus hydrometallurgischen, elektrochemischen und pyrometallurgischen Prozessen gewonnen und stellt schwarze Metallpartikel mit einer chemischen Reinheit von mindestens 99,990% und einer Partikelgröße von 20 bis 70 Nanometer mit einer spezifischen Oberfläche im Bereich von 3 - 7 m²/g und einer Schüttdichte von 0,4 - 0,9 g/cm² dar, die thermisch stabil bis 200°C in einer Luftatmosphäre und nicht pyrophor sind.

Im Vergleich mit in- und ausländischem Industrie-Iridium-Pulver ist das vorgeschlagene metallische Iridium-Nanopulver um eine Größenordnung besser in Bezug auf chemische Reinheit, um 5 - 10-fach besser in Bezug auf Schüttdichte, die den Verbrauch einer Masseneinheit je Volumeneinheit bezeichnet, und um 200 - 400-fach besser in Bezug auf die spezifische Oberfläche, die die Katalysatorwirksamkeit bezeichnet.

In den Vereinigten Staaten wurden Verfahren zur Iridium-Schichtung auf die Erzeugnisse entwickelt, die unter scharfen Bedingungen, insbesondere für Raketendüsen, verwendet werden. Eine hitzebeständige, korrosionsbeständige Beschichtung auf der Arbeitsfläche der Brennkammer und der Raketenmotordüse sichert eine Temperaturerhöhung von 1300°C (ausfahrbare Motoren) auf 2000 - 2100°C. Dadurch erhöht sich die Effizienz des Brennstoffverbrauchs und der Nutzlast. (siehe www.fazwest.com).

Zur Erreichung dieses Ziels wurde ein Verfahren zur chemischen Dampfphasenabscheidung (CVD) unter Verwendung von komplexen organischen Verbindungen des Iridiums von ihnen ausgewählt. Diese metallorganischen Verbindungen sind teuer in der Herstellung und erfordern spezielle Synthesebedingungen. Das Gasphasenverfahren selbst ist unter Verwendung dieser Verbindungen in der Zone der Beschichtung schwerlich lokalisiert. Daher werden 70 - 80% des Iridiums von den Kammerwänden und nur 20 - 30% auf der gewünschten Oberfläche assimiliert.

Bekannt ist auch die klassische Technologie der Herstellung von Tiegeln aus Iridium (vgl. Timofeev N.I., Eramakov A.V., Dmitriev V.A., Panfilov P.E. Grundlagen der Metallurgie und Technologien zur Herstellung von Erzeugnissen aus Iridium. Jekaterinburg: UrO RAN, 1996, Prototyp), die aus folgenden Operationen besteht:
- Gewinnung von metallischem Kompakt;
- durch Pressung des Ausgangspulvers GOST 12338-81 induktive Oxydationsschmelze im Periklastiegel;
- Autoklavbehandlung;
- Schmieden vom Block;
- Elektronenstrahlvakuumschmelze in der waagrechten Kokille;
- tiegelfreie Elektronenzonenschmelze;
- Kristallzüchtungsschmieden (2000 - 1100°C);
- Herstellung einer Platine;
- Heißwasservorweiche in Königswasser;
- Walzen (1000 - 800°C), Herstellung von Platten;
- Heißwasservorweiche in Königswasser;
- Herstellung einer Tiegelhülle (600 - 800°C);
- Heißwasservorweiche in Salzsäure;
- Schweißen einer Hülle und Anschweißen eines Bodens an diese;
- Tempern des Tiegels bei 1100°C;
- Polieren.

Die Metallausbeute in Fertigerzeugnissen beträgt 60 - 65% mit Totalverlusten bis zu 1,3%.

Die Nachteile bestehen in einer großen Anzahl von Operationen, einer kleinen Ausgabe von Fertigproduktion und einem hohen Selbstkostenpreis.

### Offenbarung der Erfindung

Die technische Aufgabe der vorliegenden Erfindung besteht darin, eine neue Technologie zu schaffen, die Folgendes bietet:
- Ausschließung einer teuren Ausrüstung für das Elektronenstrahlumschmelzen im Vakuum und Monokristallzüchtung des Iridiums;
- Metallausbeuteerhöhung in fertigen Erzeugnissen um das 1,5-fache;
- Reduktion des Produktionszyklus um das Vielfache;
- eine signifikante Minderung der Totalverluste des Iridiums;
- Selbstkostensenkung für die Herstellung von Erzeugnissen um das 1,5 - 2-fache;
- Konjugation mit traditioneller Technologie in jedem Stadium.

Das technische Ergebnis erhält man aufgrund der Anwendung des Iridiums in Form von hochreinem Iridium-Nanopulver in Erzeugnissen, die in verschiedenen Bereichen der Industrie und Medizin anwendbar sind und die mit erstaunlichen physikalisch-chemischen und physikalisch-mechanischen Eigenschaften verbunden sind.

Zur Lösung der gestellten Aufgabe wird ein Verfahren zur Gewinnung von Erzeugnissen aus Iridium empfohlen, das auf der Verwendung von metallischem Nanopulver des Iridiums mit einer Reinheit von mindestens 99,99 Massen-% basiert, das durch die Originalkombination von hydrometallurgischen, elektrochemischen und pyrometallurgischen Prozessen erhalten wurde und das dadurch gekennzeichnet ist, dass das Ausgangsmaterial in ein Nanopulver mit einer Partikelgröße von weniger als 100 nm umgewandelt wird, aus welchem durch Pressung bei Raumtemperatur die Aufbringung des späteren Erzeugnisses mit folgenden Backverfahren erhalten wird.

Die Verwendung von hochreinem Nanopulver verbessert die Verbrauchereigenschaften von Erzeugnissen aufgrund der Abwesenheit von Zwischengitterstörstellen und Schweißnähten, die zum Ausfall des Erzeugnisses führen.

### Gewerbliche Anwendbarkeit

Daher kann man hinzufügen, dass die Verwendung von Iridium mit Prozessen verbunden wird, bei denen es unersetzbar ist (Züchtung der Oxidkristalle) oder mit Erzeugnissen, die eine minimale Materialintensität haben, aber unter sehr scharfen Bedingungen ausgenutzt werden:
- in Gammastrahlungsquellen Ir¹⁹² als Spitzen in Zündkerzen von Verbrennungsmotoren, in Hochtemperaturthermoelementen und korrosionsbeständigen Beschichtungen von Anoden;
- Bildung der Kombinationswerkstoffe auf der Basis von Edelmetallen, die in der Medizin (Kardio- und Neurostimulatoren) anwendbar sind, sowie Bildung der industriellen Kombinationswerkstoffe auf der Basis von Nickel und Titan, die vor allem in der Luftfahrt anwendbar sind, was mit positivem Einfluss von sogar kleinen Zusätzen dieses Metalls auf technologische und Betriebseigenschaften von Erzeugnissen begründet ist, die aus diesen Materialien erhalten werden.

Die Anwendung von hochreinem metallischen Iridium-Nanopulver ermöglicht die Herstellung von nahtlosen Rohrluppen aus Iridium, die durch Warmwalzen auf die gewünschte Größe des Raketeneinsatzes erhitzt werden.

### Ausführungsbeispiel der Erfindung

Beispiele zur Gewinnung von Erzeugnissen aus Iridium:
1. Verfahren zur Gewinnung von Erzeugnissen aus Iridium, Behältermaterial (Tiegel) zur Herstellung von optischen Monokristallen der Lasertechnik und Mikroelektronik
   Hochreines Iridium-Nanopulver wird in eine elastische hermetische Hülle geladen und im Laufe von 30 Minuten bei einer Vibrationsfrequenz von 50 Hz vibriert. Durch isostatisches Pressen mit einem Druck von 150 - 350 MPa bei Raumtemperatur wird das Erzeugnis mit anschließendem Backverfahren bei einer Temperatur von 1000 - 1350°C gebildet.
2. Verfahren zur Herstellung von Erzeugnissen, Draht aus Iridium
   Hochreines Iridium-Nanopulver wird in eine elastische hermetische Hülle geladen und im Laufe von 30 Minuten bei einer Vibrationsfrequenz von 50 Hz vibriert. Durch isostatisches Pressen mit einem Druck von 150 - 350 MPa bei Raumtemperatur wird die Aufbringung in Form eines zylinderförmigen Stabs mit anschließendem Backverfahren bei einer Temperatur von 1000 - 1350°C gebildet. Der Stab wird dann verwendet, um den Iridiumdraht mit dem gewünschten Durchmesser herzustellen.

## Patentansprüche

1. Verfahren zur Herstellung eines Erzeugnisses aus metallischem Iridium, das sich **dadurch kennzeichnet, dass** chemisch hochreines metallisches Iridium mit einer Reinheit von nicht weniger als 99,99 Gew.%, als Nanopulver mit einer Partikelgröße von <100 nm, in eine elastische hermetische Hülle geladen wird, im Laufe von 30 Minuten bei einer Vibrationsfrequenz von 50 Hz vibriert wird, anschließend ein isostatisches Pressen mit einem Druck von 150-350 MPa bei Raumtemperatur und ein daran anschließendes Backverfahren bei einer Temperatur von 1000-1350°C durchgeführt wird mit Erhalt eines nahtlosen Erzeugnisses mit einer isotropen Struktur mit einer Korngröße von 100-300 nm.

## Claims

1. A process for the production of a metallic iridium product **characterised in that** chemically high purity metallic iridium having a purity of not less than 99.99% by weight, as a nanopowder having a particle size of <100 nm, is loaded into an elastic hermetic envelope, is vibrated for 30 minutes at a vibration frequency of 50 Hz, followed by isostatic pressing at a pressure of 150-350 MPa at room temperature and subsequent baking at a temperature of 1000-1350°C to obtain a seamless product with an isotropic structure with a grain size of 100-300 nm.

## Revendications

1. Procédé pour la production d'un produit à base d'iridium métallique se caractérisant de sorte que l'iridium chimique de haute pureté est chargé avec une pureté de non pas moins de poids de 99,99% en qualité de nanopoudre avec une granulométrie de <100 nm dans une coque élastique hermétique vibrant au cours de 30 minutes dans une fréquence de vibration de 50 Hz et que par la suite une compression isostatique de pression de 150-350 MPa dans une température ambiante et un traitement de cuisson dans une température de 1000-1350 C sont exécutés avec la préservation d'un produit sans soudure avec une structure isotrope avec une grosseur de grain de 100-300 nm.
